# FASCICULE DE BREVET EUROPEEN

(11) **EP 2 559 052 B1**
(45) Date de publication et mention de la délivrance du brevet: **07.03.2018**
(21) Numéro de dépôt: 11714287.7
(22) Date de dépôt: 13.04.2011
(51) Int. Cl.: G03F 1/78, G06F 17/50, H01J 37/317

(54) **PROCEDE DE LITHOGRAPHIE ELECTRONIQUE AVEC CORRECTION DE FINS DE LIGNES PAR INSERTION DE MOTIFS DE CONTRASTE**
ELEKTRONENSTRAHLLITHOGRAFIEVERFAHREN MIT KORREKTUR VON ZEILENENDEN MITTELS EINFÜGEN VON KONTRASTMUSTERN
ELECTRON-BEAM LITHOGRAPHY METHOD WITH CORRECTION OF LINE ENDS BY INSERTION OF CONTRAST PATTERNS

(30) Priorité: 15.04.2010 FR 1052863
(43) Date de publication de la demande: 20.02.2013
(73) Titulaire: Commissariat à l'Énergie Atomique et aux Énergies Alternatives, 75015 Paris (FR)
(72) Inventeur: MANAKLI, Serdar, F-38300 Meyrie (FR)
(74) Mandataire: Nguyen Van Yen, Christian
(86) Numéro de dépôt international: PCT/EP2011/055843
(87) Numéro de publication internationale: WO 2011/128383

(56) Documents cités:
- WO-A1-2007/129135
- JP-A- 2004 071 767
- US-A- 5 849 437
- US-A1- 2001 044 055
- US-A1- 2003 054 580
- US-B1- 6 316 164
- US-B1- 6 361 911
- OCOLA L E: "Nanoscale geometry assisted proximity effect correction for electron beam direct write nanolithography", JOURNAL OF VACUUM SCIENCE & TECHNOLOGY B (MICROELECTRONICS AND NANOMETER STRUCTURES), vol. 27, no. 6, 1 décembre 2009 (2009-12-01), pages 2569-2571, XP002613384, AMERICAN VACUUM SOCIETY BY THE AMERICAN INSTITUTE OF PHYSICS, USA ISSN: 1071-1023, DOI: 10.1116/1.3237135
- MANAKLI S ET AL: "New electron beam proximity effects correction approach for 45 and 32 nm nodes", JAPANESE JOURNAL OF APPLIED PHYSICS, PART 1 (REGULAR PAPERS, SHORT NOTES & REVIEW PAPERS), vol. 45, no. 8A, 4 août 2006 (2006-08-04), pages 6462-6467, XP002613385, JAPAN SOC. APPL. PHYS. JAPAN ISSN: 0021-4922, DOI: 10.1143/JJAP.45.6462 cité dans la demande

## Description

La présente invention s'applique au domaine de la lithographie électronique. Pour permettre la gravure de motifs dont la dimension critique est inférieure à 50nm, il faut intégrer dans les procédés de photolithographie optique des méthodes de correction des distorsions optiques de plus en plus complexes à la fois au stade de la conception et de la production des masques et au stade de l'exposition. Les coûts des équipements et des développements pour une nouvelle génération de technologie augmentent en conséquence dans des proportions très élevées. Aujourd'hui, les dimensions critiques accessibles en photolithographie sont supérieures ou égales à 65 nm. La génération 32-45 nm est en cours de développement et il n'existe pas de solution viable envisagée pour les noeuds technologiques inférieurs à 22 nm. De son côté, la lithographie électronique permet dores et déjà la gravure de motifs de 22 nm ; elle ne nécessite pas de masque et offre un temps de développement assez court, ce qui permet une meilleure réactivité et flexibilité dans la réalisation d'améliorations aux technologies et aux designs. En revanche, les temps de production sont structurellement sensiblement plus élevés qu'en photolithographie puisqu'il faut réaliser une exposition par pas (avec un « stepper »), alors que la photolithographie ne nécessite qu'une exposition par couche.

Le ou les faisceaux d'électrons utilisés pour effectuer la gravure d'un motif diffusent notamment sur courte distance (forward scattering ou blur) dans la résine et le substrat sur les bords du centre du faisceau, ce qui accroit la taille du faisceau et en réduit le contraste. De plus, les électrons sont complètement rétrodiffusés sur une longue distance (backward scattering). En particulier, les fins de lignes au sein de réseaux denses vont être raccourcies (« line end shortening » ou LES), ce qui affecte la fonctionnalité du composant et diminue donc le rendement de production.

Un certain nombre de procédés de l'art antérieur, dans les domaines de la photolithographie et de la lithographie électronique ont tenté d'apporter des corrections à ce phénomène de LES. C'est notamment le cas en photolithographie des procédés prévoyant les modifications des motifs à graver, notamment par extension de leur surface en fin de ligne, tel que ceux divulgués par K. Tsudaka et alii, Japanese Journal of Applied Physics, Vol. 36 (1997), pp. 7477-7481, K. Kim et alii, Japanese Journal of Applied Physics, Vol. 37 (1998), pp. 6681-6685 ainsi que par le brevet US 7,494,751. Des procédés similaires ont été appliqués en lithographie électronique, tels que ceux divulgués notamment par S. Manakli et alii, Japanese Journal of Applied Physics, Vol. 45, N°8A, 2006, pp. 6462-6467, dans lequel les dimensions des lignes sont modifiées en fonction de règles, et la demande de brevet internationale publiée sous le numéro WO2007/129135, dans lequel une ligne est remplacée par plusieurs lignes de largeurs et d'espacements choisis. Des solutions partielles ont été proposées, notamment par le brevet US 5,849,437. Mais ce procédé ne s'applique qu'aux réseaux de lignes en quadrillage dont le pas de résolution est de l'ordre de 10 microns. Il reste donc à trouver une solution permettant la correction des LES en procurant une résolution suffisante pour les noeuds technologiques inférieurs ou égaux à 22 nm.

La présente invention résout ce problème en permettant le calcul puis l'insertion de motifs d'amélioration de contraste (« Contrast Improvement Features » ou CIF) dans les réseaux de lignes à graver.

A cet effet, l'invention prévoit des procédés de lithographie électronique de réseaux de lignes sur un substrat résiné comprenant selon les revendications 1, 3, 6 et 8. une étape de détermination d'un type d'au moins une structure d'intensification de contraste. Avantageusement, ladite structure d'intensification de contraste est une structure en H, dont chacune des branches a des dimensions propres comprises entre environ 5 et 50 nm, dont la branche perpendiculaire à la direction de ladite ligne critique est placée au milieu du gap à une distance S2 de la fin de ladite ligne critique selon la direction parallèle à ladite ligne critique comprise entre environ 5 et 50 nm et dont les branches parallèles à la direction de ladite ligne critique sont placées de manière symétrique de part et d'autre de ladite ligne critique à une distance S3 perpendiculaire à la direction de ladite ligne critique comprise entre environ 5 et 50 nm.

Avantageusement, ladite structure d'intensification de contraste est constituée de deux barres parallèles placées de manière symétrique dans le gap selon une direction perpendiculaire à ladite ligne critique, chacune des barres ayant des dimensions propres comprises entre environ 5 et 50 nm, espacées d'une distance S2 comprise entre environ 5 et 100 nm et espacées chacune de la fin de ladite ligne critique d'une distance S4 perpendiculaire à ladite ligne critique comprise entre environ 5 et 50 nm.

Avantageusement, lesdites deux barres parallèles comprennent en outre en chacune de leurs extrémités quatre plots de dimensions propres comprises entre environ 5 et 50 nm.

Avantageusement, ladite structure d'intensification de contraste est constituée par au moins deux CIF (CIF1, ... CIFᵢ...) ayant des dimensions propres (Lᵢ, lᵢ) substantiellement comprises entre 5 et 50 nm, lesdits motifs étant séparés l'un de l'autre par une distance S5 perpendiculaire aux lignes critiques sensiblement comprise entre 5 et 20 nm, le nombre de motifs étant choisi de telle manière que les plots extérieurs soient placés de manière symétrique de part et d'autre des bords des lignes critiques à une distance S3 perpendiculaire à la direction desdites lignes critiques comprise entre environ 5 et 50 nm.

Avantageusement, ladite structure d'intensification de contraste est constituée par deux rangées de plots sensiblement carrés traversant l'intérieur du gap, de dimension propre sensiblement comprise entre 5 et 20 nm, les deux rangées étant séparées d'une distance S5 dans la direction de la ligne critique sensiblement comprise entre 5 et 50 nm, le nombre de plots étant choisi de telle manière que les plots extérieurs soient placés de manière symétrique de part et d'autre des bords des lignes critiques à une distance S3 perpendiculaire à la direction desdites lignes critiques comprise entre environ 5 et 50 nm.

Avantageusement, lesdits types de structures d'intensification de contraste, leurs dimensions et leurs emplacements sont déterminés par un modèle de détermination automatique d'un design cible comprenant les lignes critiques et les structures d'intensification de contraste optimales.

Avantageusement, le procédé de l'invention comprend en outre au moins une étape de calcul d'au moins une dimension de ladite ligne critique et d'au moins une dimension d'une structure d'intensification de contraste et une étape de calcul de modulation de doses sur lesdites ligne critique et structure d'intensification de contraste, lesdits calculs étant liés par un critère d'optimisation choisi dans le groupe comprenant la latitude en énergie du procédé, la forme de la structure d'intensification de contraste, la position de ladite structure d'intensification de contraste, une combinaison de cette dernière avec la latitude en énergie du procédé.

Pour mettre en oeuvre le procédé, l'invention prévoit également un programme d'ordinateur selon la revendication 12. Avantageusement, le programme de l'invention comprend en outre un module de calcul d'au moins une dimension de ladite ligne critique et d'au moins une dimension d'une structure d'intensification de contraste et un module de calcul de modulation de doses sur lesdites ligne critique et structure d'intensification de contraste, lesdits calculs étant liés par un critère d'optimisation choisi dans le groupe comprenant la latitude en énergie du procédé, la forme de la structure d'intensification de contraste, la position de ladite structure d'intensification de contraste, une combinaison de cette dernière avec la latitude en énergie du procédé.

L'invention utilise un petit nombre de géométries types de CIF dont le calcul et le placement peuvent être automatisés, ce qui autorise la modification des bibliothèques de composants standards par intégration de programmes adaptés dans les outils de conception assistée par ordinateur.

Bien qu'ils soient en nombre réduit pour faciliter cette automatisation de la conversion des bibliothèques de composants, ces CIF ont un nombre de paramètres élevé dont la variation, combinée le cas échéant avec celle des paramètres des motifs de base du réseau permet une correction très fine des effets de proximité et une reproduction très fidèle desdits motifs de base.

L'invention sera mieux comprise, ses différentes caractéristiques et avantages ressortiront de la description qui suit de plusieurs exemples de réalisation et de ses figures annexées dont :
- La figure 1 représente une vue d'un motif à reproduire et d'un motif reproduit, sans correction des LES et avec correction des LES dans un procédé de photolithographie de l'art antérieur;
- La figure 2 représente une vue d'un motif à reproduire et d'un motif reproduit, sans correction des LES et avec correction des LES dans un procédé de lithographie électronique de l'art antérieur ;
- Les figures 3 et 3a représentent plusieurs exemples de réalisation de corrections des LES par un procédé de lithographie selon l'invention;
- La figure 4 est un organigramme des traitements mis en oeuvre pour réaliser une correction des LES selon un mode de réalisation de l'invention;
- La figure 5 est un détail d'une étape de l'organigramme de la figure 4 selon deux modes de réalisation de l'invention ;
- La figure 6 illustre le procédé de resizing des géométries à graver selon une variante de l'invention ;
- La figure 7 illustre le calcul des paramètres d'un CIF dans un des modes de réalisation de l'invention ;
- La figure 8 illustre le calcul des paramètres d'un CIF dans un autre des modes de réalisation de l'invention ;
- Les figures 9, 9a, 9b et 9c illustrent le calcul des paramètres d'un CIF dans encore plusieurs autres modes de réalisation de l'invention ;
- Les figures 10a, 10b et 10c illustrent les résultats d'un procédé de correction de LES de l'art antérieur ;
- Les figures 11a, 11b, 11c et 11d illustrent les résultats d'un procédé de correction de LES dans un mode de réalisation de l'invention.

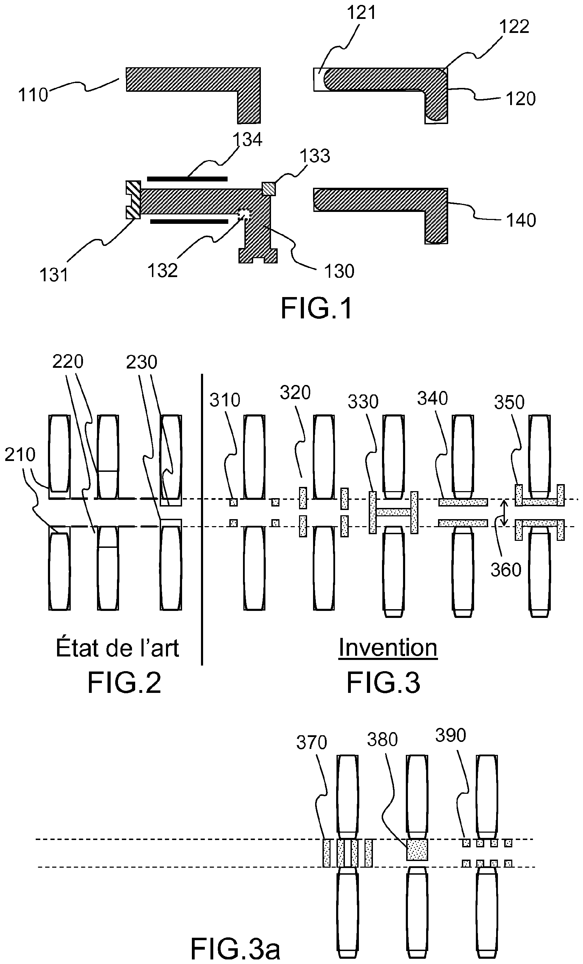

La figure 1 représente une vue d'un motif à reproduire et d'un motif reproduit, sans correction des LES et avec correction des LES dans un procédé de photolithographie de l'art antérieur.

Le motif 110 à reproduire est transféré dans la résine sous la forme d'une image déformée 120. En particulier, cette image comporte un raccourcissement de fin de ligne (LES), 121 et des arrondissements de coins tels que 122, du fait de l'effet de réduction de contraste aux extrémités du motif.

Le motif 130 à reproduire est modifié par adjonction de motifs sous-résolus tels qu'une « tête de marteau » ou « hammerhead », 131, un empattement ou « serif », 133, ou une ou plusieurs barres de diffusion ou « scattering bar », 134. Le motif peut également être une soustraction de matière telle qu'une « morsure de souris » ou « mousebite », 132. L'impact d'un faisceau électronique modulé de manière particulière avec ces motifs sous-résolus crée une répartition d'énergie sur l'échantillon qui améliore le contraste et transfère le motif modifié par ces adjonctions et soustractions dans la résine avec une image, 140, identique au motif initial avant adjonctions/soustractions.

La figure 2 représente une vue d'un motif à reproduire et d'un motif reproduit, sans correction des LES et avec correction des LES dans un procédé de lithographie électronique de l'art antérieur.

Dans un procédé de lithographie électronique par écriture directe, il apparaît également un effet LES de raccourcissement de fin de ligne, 210. Cet effet LES peut être corrigé en modifiant la géométrie de la fin de ligne, en la rallongeant, comme en 220 ou 230.

Les figures 3 et 3a représentent plusieurs exemples de réalisation de corrections des LES par un procédé de lithographie selon l'invention.

On considère essentiellement des réseaux dans lesquels deux fins de lignes situées en opposition constituent un gap entre elles.

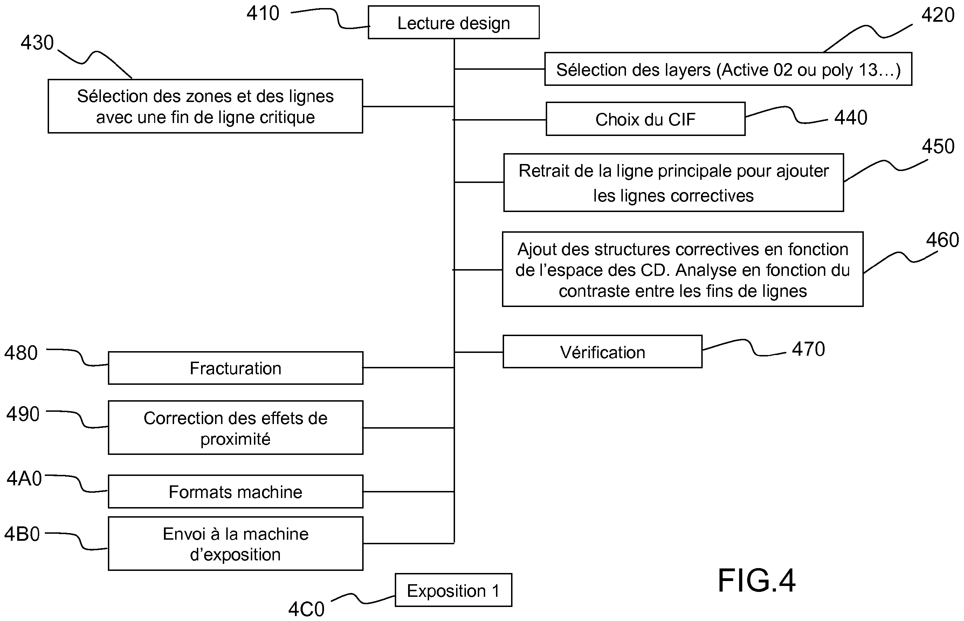

L'idée est d'insérer dans le réseau à graver des motifs d'amélioration de contraste, 310, 320, 330, 340, 350, 370, 380, 390 de géométrie et d'emplacement appropriés. La manière de calculer la géométrie et l'emplacement de ces motifs sera détaillée en commentaires aux figures 4 à 9. On utilise principalement deux types de motifs :
- les motifs de type 310 et 320 dont aucune partie ne s'intercale dans une zone située entre deux fins de lignes ; on choisit en règle générale des motifs de ces types lorsque la dimension caractéristique de cette zone, 360, est inférieure à environ 10 nm ; plus spécifiquement, de manière empirique, on choisira des motifs de type 310 lorsque la dimension 360 est inférieure ou égale à 5 nm et des motifs de type 320 lorsque la dimension 360 est supérieure à 5 nm mais inférieure ou égale à 10 nm ;
- les motifs de types 330, 340 ou 350 dans lesquels il existe au moins un élément perpendiculaire aux lignes situé dans la zone entre deux fins de lignes ;
- les motifs de type 380, dans lequel un seul motif est inséré dans le gap ;
- les motifs de type 370, dans lequel la dimension la plus grande de chacun des motifs est parallèle aux lignes du réseau ;
- les motifs de type 390, dans lequel plusieurs plots constituant deux rangées alignées perpendiculairement aux lignes du réseau sont insérées dans le gap.

Les rétrécissements de fins de ligne augmentent en proportion du motif à graver pour les technologies les plus fines. Pour les technologies en 32-45 nm, le rétrécissement atteint 30 nm par bord de ligne. Si l'espacement est suffisant (typiquement supérieur à 10 nm), on choisira de manière préférentielle l'une des configurations 330, 340, 350 dans lesquelles les surdosages appliqués sur les parties de motifs CIF situées dans l'espacement permettent une augmentation de la latitude en énergie (EL) du procédé (redressement de la pente de la courbe de dose) et donc une augmentation du contraste. Lorsque l'espace entre fins de lignes est trop réduit pour permettre l'insertion d'un motif ayant une partie dans ce gap, on choisit l'une des configurations 310, 320.

La figure 4 est un organigramme des traitements mis en oeuvre pour réaliser une correction des LES. De manière classique pour un homme de l'art, le procédé de l'invention commence par une étape, 410, de lecture du design. Le lay-out des motifs à graver est classiquement encodé dans des fichiers au format GDS Il (Graphie Data System version2) ou OASIS (Open Artwork System Interchange Standard).

On sélectionne ensuite au cours d'une étape 420 les couches où les motifs doivent être gravés.

Au cours d'une étape 430, on identifie les zones, lignes et fins de lignes critiques, c'est-à-dire devant faire l'objet d'un traitement spécifique. Le seuil au dessous duquel les fins de lignes doivent faire l'objet d'un traitement spécifique dépend de la technologie ; ainsi pour une technologie 22 nm, les fins de lignes critiques seront celles ayant un gap inférieur ou égal à environ 30 nm. De manière générale, on traitera toutes les fins de lignes pour lesquelles les rétrécissements sont supérieurs à 10%. La valeur du seuil dépend donc de la technologie.

Au cours d'une étape 440, on choisit le type du motif CIF à implanter en fonction de la configuration de la fin de ligne à traiter. Pour des espaces de fins de lignes inférieurs à 5 nm, seul un CIF du type 310 de la figure 3 est possible. Pour des espaces de fins de lignes compris entre 5 et 10 nm, on privilégie un CIF du type 320, bien qu'un CIF de type 310 soit également possible, avec des performances moins bonnes en termes d'augmentation de contraste.

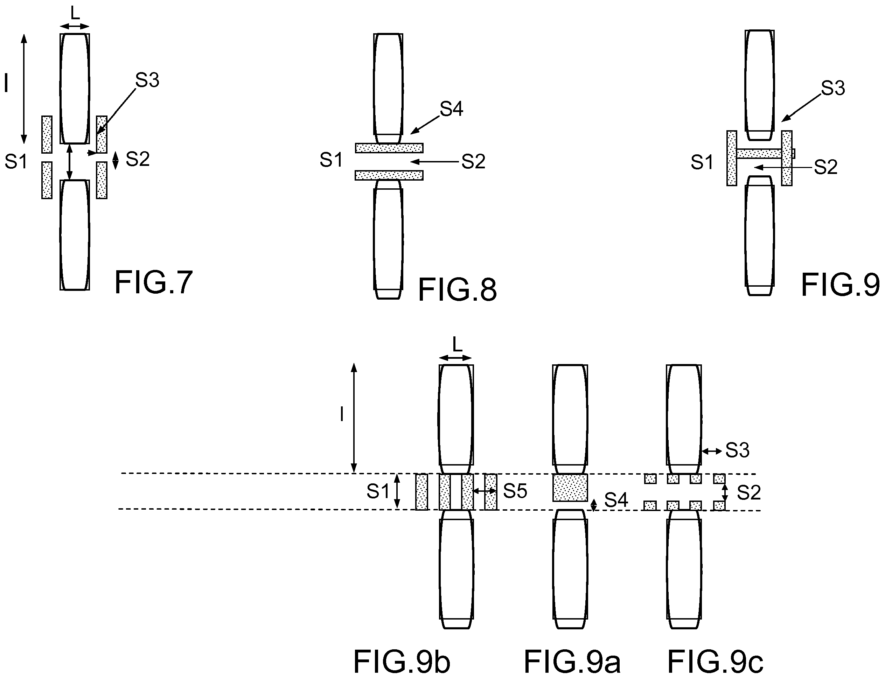

Au cours d'une étape 450, on calcule et réalise le retrait des lignes dans le cas où, en sortie de l'étape 440, on a décidé d'implanter un CIF de type 330, 340, 350, 370, 380 ou 390. Le calcul s'effectue comme indiqué plus loin en commentaire aux figures 8, 9, 9a, 9b et 9c.

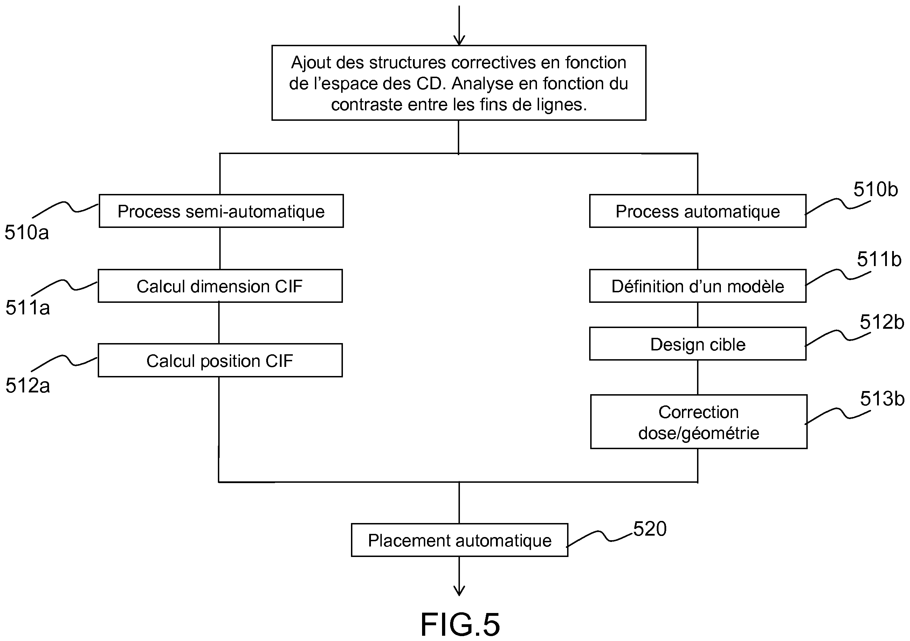

L'étape 460 d'ajout des CIF est commentée de manière détaillée en relation avec la figure 5.

Le lay-out modifié est ensuite vérifié au cours d'une étape 470. Sont en particulier vérifiés, les espaces de fins de lignes, les erreurs éventuelles de CD, les défauts de fracturation et les calculs de doses.

Dans le cas où un utilise un procédé de lithographie par projection de formes, on réalise ensuite une étape 480 de fracturation du design à reproduire en formes élémentaires à projeter.

Au cours d'une étape 490 on corrige les effets de proximité de nature différente des LES, notamment ceux qui se produisent en bord de réseau dense. On peut utiliser à cet effet un procédé de l'art antérieur tel que celui faisant appel à une modulation des doses de rayonnement en fonction de la position du shot dans le réseau. Mais on peut également utiliser le procédé de l'invention faisant l'objet de la demande de brevet n° 1052862 déposée par le demandeur de la présente demande. Dans ce cas, la correction passe par un resizing des lignes permettant de réduire les doses rayonnées par ces shots.

Au cours des étapes 4A0, 4B0 et 4C0, les données finales de design sont respectivement converties en format machine, transférées vers la machine d'exposition et utilisées par ladite machine pour réaliser l'exposition.

Dans le procédé de l'invention, on peut utiliser n'importe quel dispositif de lithographie électronique, par exemple une machine de marque VISTEC™ ou ADVANTEST™. Son logiciel de pilotage est adapté de manière à pouvoir mettre en oeuvre les différentes étapes décrites ci-dessus.

La figure 5 est un détail d'une étape de l'organigramme de la figure 4. L'étape 460 de la figure 4 est maintenant détaillée. Cette étape consiste à calculer les dimensions des CIF à implanter en fonction du contraste des fins de lignes. Cette étape 450 peut être réalisée de manière semi-automatique ou de manière complètement automatique.

Dans le premier cas, au cours de cette étape, 510a, on définit un nouveau motif à graver de la même manière que les motifs de base à reporter sur le substrat. Au cours d'une étape 511a, on calcule les dimensions des CIF et au cours d'une étape 512a on calcule l'emplacement des CIF par rapport aux fins de ligne selon des modalités qui sont explicitées plus loin dans la description. Puis, de manière classique, le placement des CIF, dont les paramètres ont été entièrement déterminés au cours des étapes précédentes, est effectué de manière automatique au cours d'une étape 520. Dans le deuxième cas, au cours d'une étape 510b, les dimensions et les emplacements des CIF sont définis de manière entièrement automatique en utilisant une approche basée sur une modélisation des structures CIF à implanter en fonction des caractéristiques du réseau de lignes à graver. Au cours d'une étape 511b, on définit le modèle à appliquer et, au cours d'une étape 512b, le design cible. Cette modélisation est explicitée en commentaire aux figures 8 et 9 ci-dessous.

A titre de variante de réalisation, on peut effectuer, au cours d'une étape 513b, un resizing du design cible en utilisant le procédé d'optimisation combinée de la géométrie du CIF et des lignes et de la modulation de dose rayonnée selon le procédé divulgué par la demande de brevet déposée par la demanderesse de la présente demande sous le numéro 1052862.

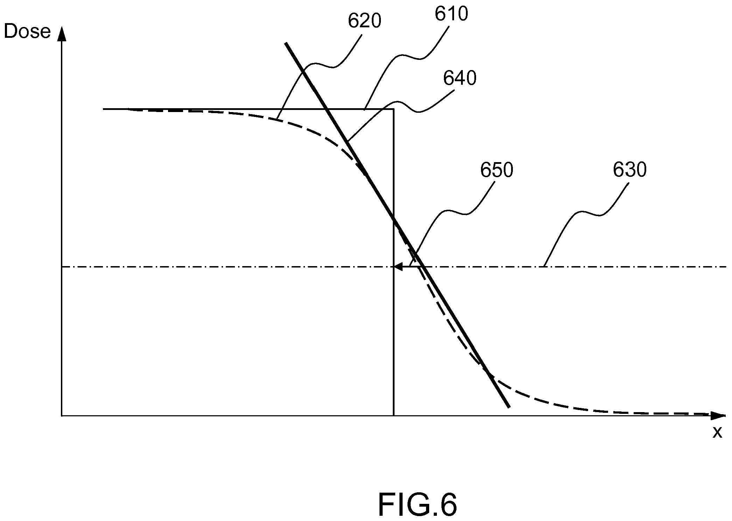

Selon le procédé décrit par cette demande de brevet, qui vise une correction des effets de proximité inhérents aux procédés de lithographie pour les géométries inférieures à 50 nm, on calcule les doses à appliquer dans les shots correspondant aux motifs du CIF et des lignes critiques, soit par convolution de la dose rayonnée avec le motif à graver soit en utilisant une table de paramètres. Le calcul combiné de la modulation de dose à appliquer et de la taille des motifs nouveaux est effectué de manière à préserver la latitude en énergie du procédé selon un calcul dont un exemple est donné ci-dessous en commentaire à la figure 6.

La figure 6 illustre le procédé de resizing des géométries à graver.

La géométrie des motifs est modifiée dans au moins une dimension pour optimiser la latitude en énergie du procédé. Plus précisément, on calcule le déplacement 650 à effectuer selon cette dimension en recherchant l'intersection de la droite 640 (tangente à la courbe de dose reçue 620 au point où la dose reçue est égale au seuil de sensibilité de la résine à 0,5) avec la droite 630 qui matérialise ledit seuil de sensibilité, puis en effectuant le déplacement vers le point d'intersection de cette dernière droite avec le profil de la dose rayonnée 610.

La géométrie et/ou la dose des motifs est modifiée dans au moins une des dimensions pour optimiser la latitude en énergie ou la forme ou la position des lignes critiques. On peut calculer le déplacement 650 en effectuant des incréments progressifs de ladite géométrie et en ajustant le sens et la valeur de ces incréments après avoir comparé la quantité à optimiser (géométrie ou latitude ou combinaison des deux ou toute autre fonction de coût) à un objectif. Le déplacement 650 peut se faire en utilisant toute autre approche utilisée dans les problèmes d'optimisation ou d'asservissement

Le calcul combiné dose/motifs peut être itéré deux ou trois fois.

La modulation de la dose à appliquer sur les motifs peut également être calculée à partir d'une table de paramètres sans calcul de convolution, notamment lorsque la modulation n'est appliquée que sur les shots extérieurs aux motifs, les autres shots étant appliqués à la valeur normalisée du procédé, ou à une valeur inférieure de l'ordre de 30% à celle-ci.

Les figures suivantes illustrent les règles de calcul des variations à appliquer aux paramètres de dimensionnement de la « main line » (ou ligne du motif à graver) à et des CIF qui sont définis ci-après :
- L (main line) est la largeur de la main line à graver ;
- l (main line) est la longueur de la main line à graver ;
- L (CIF) est la largeur commune de chaque CIF à implanter ;
- lᵢ (CIF) sont les longueurs caractéristiques de chaque CIF à implanter ;
- S1 est la dimension du gap entre deux main lines opposées ;
- S2 est la dimension du gap entre deux CIF selon la direction de la main line ;
- S3 est la dimension du gap entre un CIF et la main line selon la direction perpendiculaire à la main line ;
- S4 est la dimension du gap entre un CIF et la main line selon la direction de la main line ;
- S5 est la dimension du gap entre deux CIF selon la direction perpendiculaire à la main line.

Par référence à la figure 7 qui illustre le calcul des paramètres du procédé dans un des types 310 et 320 de la figure 3, sont indiquées les règles de calcul des paramètres de la main line et des CIF :
- Les paramètres L (main line) et l (main line) ne sont pas modifiés ;
- Le paramètre S1 est fixé par le minimum du Design Rule Manual (DRM); dans le cas du process 22 nm et d'une résine adaptée, il est égal à environ 30 nm ;
- L (CIF) et lᵢ (CIF) sont compris entre environ 5 et 20 nm ;
- S2 et S3 sont fixés à des valeurs comprises entre environ 5 et 20 nm.

Avantageusement, on peut réaliser un recul dans le cas des structures denses en technologie 16 nm. Ce recul procurera un gain de contraste par rapport à une solution sans recul qui est la solution de référence pour les CIF de ces deux types pour les technologies moins fines.

Par référence à la figure 8 qui illustre le calcul des paramètres du procédé de l'invention dans un des types 340 et 350 de la figure 3, sont indiquées les règles de calcul des paramètres de la main line et des CIF :
- Le paramètre L (main line) est corrigé d'un retrait calculé en fonction du CIF ;
- Le paramètre l (main line) n'est pas modifié ;
- Le paramètre S1 est fixé par le minimum du Design Rule Manual (DRM); dans le cas du process 22 nm et d'une résine adaptée, il est égal à environ 30 nm ;
- L (CIF) et lᵢ (CIF) sont compris entre environ 5 et 50 nm ;
- S2 est fixé à une valeur comprise entre environ 5 et 100 nm en fonction du retrait de la main line ;
- S4 est fixé à une valeur comprise entre environ 5 et 50 nm.

Par référence à la figure 9 qui illustre le calcul des paramètres du procédé de l'invention dans le type 330 de la figure 3, sont indiquées les règles de calcul des paramètres de la main line et des CIF :
- Le paramètre L (main line) est corrigé d'un retrait calculé en fonction du CIF ;
- Le paramètre l (main line) n'est pas modifié ;
- Le paramètre S1 est fixé par le minimum du Design Rule Manual (DRM); dans le cas du process 22 nm et d'une résine adaptée, il est égal à environ 30 nm ;]
- L (CIF) et l (CIF) sont compris entre environ 5 et 50 nm ;
- S2 est fixé à une valeur comprise entre environ 5 et 100 nm en fonction du retrait de la main line ;
- S3 est fixé à une valeur comprise entre environ 5 et 50 nm.

Les figures 9a, 9b et 9c illustrent le calcul des paramètres du procédé respectivement dans les types 370, 380 et 390 de la figure 3a ; on indique ci-dessous les règles de calcul des paramètres de la main line et des CIF :
- Le paramètre L (main line) est corrigé d'un retrait calculé en fonction du CIF ;
- Le paramètre l (main line) n'est pas modifié ;
- Le paramètre S1 est fixé par le minimum du Design Rule Manual (DRM); dans le cas du process 22 nm et d'une résine adaptée, il est égal à environ 30 nm ;
- L (CIF) et l (CIF) sont compris entre environ 5 et 50 nm ;
- S2 est fixé à une valeur comprise entre environ 5 et 100 nm en fonction du retrait de la main line ;
- S3, S4 et S5 sont fixés à des valeurs comprises entre environ 5 et 50 nm.

Les paramètres des figures 8, 9, 9a, 9b et 9c ci-dessus sont optimisés par essai et erreur, les valeurs optimales étant ensuite intégrées dans des abaques qu'appellent les modèles de génération de corrections.

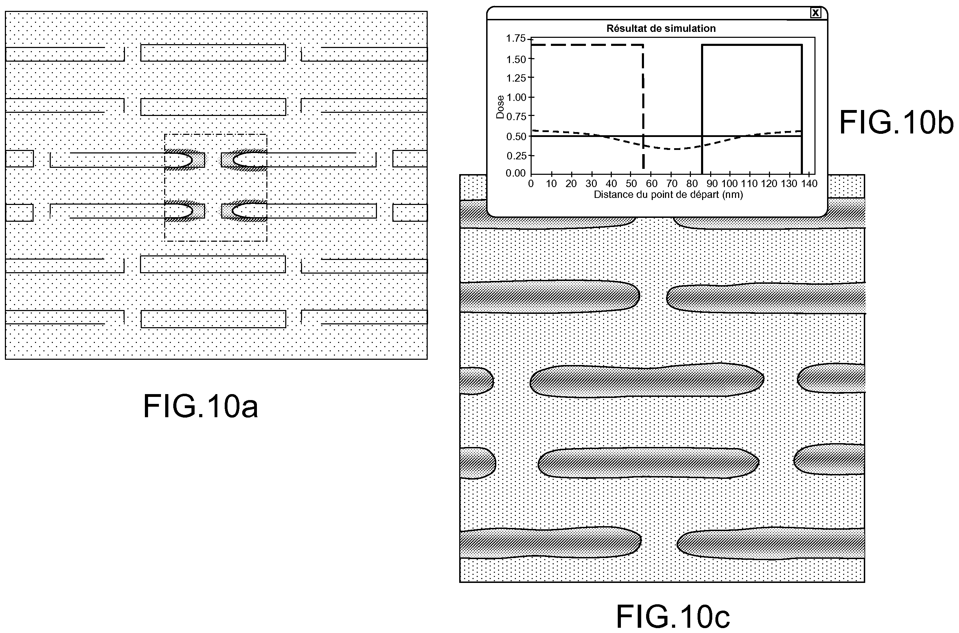

Les figures 10a, 10b et 10c illustrent les résultats d'un procédé de correction de LES de l'art antérieur.

La figure 10a illustre une simulation de deux lignes gravées en utilisant un procédé de lithographie électronique appliquant des corrections de LES de l'art antérieur, tel que celui schématisé sur la figure 2 : on voit clairement que les fins de lignes ne sont pas maîtrisées et qu'en particulier les retraits de fin de ligne sont trop importants, ce qui occasionnera nécessairement dans un nombre de cas élevé des problèmes de court-circuit fatals au circuit intégré gravé selon ce procédé. La figure 10b montre de manière graphique un résultat de simulation de la dose reçue en fonction de la distance du point de départ de la ligne. La figure 10c est une photographie du circuit gravé.

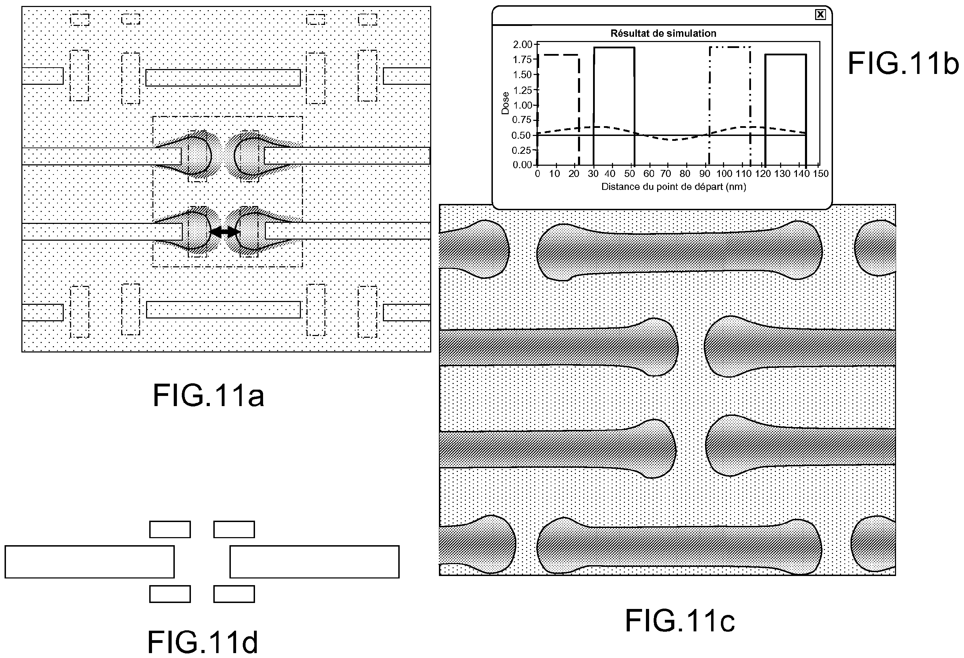

Les figures 11a, 11b, 11c et 11d illustrent les résultats d'un procédé de correction de LES dans un mode de réalisation de la demande.

La figure 11a illustre une simulation de deux lignes gravées en utilisant un procédé de lithographie électronique appliquant des corrections de LES selon un mode de réalisation de la demande (celui du type 320 de la figure 3, illustré dans cet exemple sur la figure 11d) : on voit sur la figure 11a et sur la figure 11c que les fins de lignes sont beaucoup mieux maîtrisées que dans l'application du procédé de l'art antérieur illustré par les figures 10a, 10b et 10c, et que l'on obtient exactement ce qui est souhaité dans le design. Ce résultat est confirmé par le graphe de simulation de la figure 11b où l'on constate que les CIF ont pour effet de rapprocher les fins de lignes l'une de l'autre.

Les exemples de réalisation de la présente description ont été donnés dans le cas d'un procédé de lithographie électronique par écriture directe. L'invention est cependant applicable à la gravure de masque, qui seront utilisés ensuite pour une écriture par rayonnement électronique.

Les exemples décrits ci-dessus sont donnés à titre d'illustration, le champ de l'invention est défini par les revendications qui suivent.

## Revendications

1. Procédé de lithographie électronique de réseaux de lignes sur un substrat résiné comprenant une étape de sélection d'au moins deux lignes opposées du réseau ayant chacune une fin de ligne critique en opposition, les deux lignes étant séparées par un gap entre les deux fins de lignes critiques opposées, une étape de détermination de corrections à appliquer à la géométrie de la fin desdites lignes, ledit procédé comprenant en outre une étape de détermination d'un type d'au moins une structure d'intensification de contraste (330) choisie parmi plusieurs, ladite structure d'intensification de contraste étant une structure en H ayant une branche perpendiculaire à la direction de ladite ligne critique placée au milieu du gap et deux branches parallèles à la direction de ladite ligne critique placées de manière symétrique de part et d'autre de ladite ligne critique, une étape de calcul des dimensions caractéristiques et de l'emplacement (S1, S2, S3, S4) dans le gap entre les deux fins de lignes critiques opposées de ladite structure d'intensification de contraste, une étape de génération de ladite structure et une étape de placement de ladite structure relativement aux fins desdites fins de lignes critiques opposées en fonction des paramètres déterminés.

2. Procédé de lithographie selon la revendication 1, **caractérisé en ce que** chacune des branches parallèles de la structure en H a des dimensions propres comprises entre environ 5 et 50 nm, et la branche de la structure en H perpendiculaire à la direction de ladite ligne critique est placée au milieu du gap à une distance S2 de la fin de ladite ligne critique selon la direction parallèle à ladite ligne critique comprise entre environ 5 et 50 nm et dont les branches parallèles à la direction de ladite ligne critique sont placées de manière symétrique de part et d'autre de ladite ligne critique à une distance S3 perpendiculaire à la direction de ladite ligne critique comprise entre environ 5 et 50 nm.

3. Procédé de lithographie électronique de réseaux de lignes sur un substrat résiné comprenant une étape de sélection d'au moins deux lignes opposées du réseau ayant chacune une fin de ligne critique en opposition, les deux lignes étant séparées par un gap entre les deux fins de lignes critiques opposées, une étape de détermination de corrections à appliquer à la géométrie de la fin desdites lignes, ledit procédé comprenant en outre une étape de détermination d'un type d'au moins une structure d'intensification de contraste (340, 350) choisie parmi plusieurs, ladite structure d'intensification de contraste étant constituée de deux barres parallèles placées de manière symétrique entre les deux fins de lignes selon une direction perpendiculaire à ladite ligne critique, une étape de calcul des dimensions caractéristiques et de l'emplacement (S1, S2, S3, S4) dans le gap entre les deux fins de lignes critiques opposées de ladite structure d'intensification de contraste, une étape de génération de ladite structure et une étape de placement de ladite structure relativement aux fins desdites fins de lignes critiques opposées en fonction des paramètres déterminés.

4. Procédé de lithographie selon la revendication 3, **caractérisé en ce que** chacune des barres parallèles de la structure d'intensification de contraste a des dimensions propres comprises entre environ 5 et 50 nm, espacées d'une distance S2 comprise entre environ 5 et 100 nm et espacées chacune de la fin de ladite ligne critique d'une distance S4 parallèle à ladite ligne critique comprise entre environ 5 et 50 nm.

5. Procédé de lithographie selon la revendication 4, **caractérisé en ce que** lesdites deux barres parallèles comprennent en outre en chacune de leurs extrémités quatre plots de dimensions propres comprises entre environ 5 et 50 nm.

6. Procédé de lithographie électronique de réseaux de lignes sur un substrat résiné comprenant une étape de sélection d'au moins deux lignes opposées du réseau ayant chacune une fin de ligne critique en opposition, les deux lignes étant séparées par un gap entre les deux fins de lignes critiques opposées, une étape de détermination de corrections à appliquer à la géométrie de la fin desdites lignes, ledit procédé comprenant en outre une étape de détermination d'au moins une structure d'intensification de contraste (370) choisie parmi plusieurs, ladite structure d'intensification de contraste comprenant des plots dont la plus grande dimension est parallèle auxdites deux lignes opposées séparés entre eux dans la direction perpendiculaire aux lignes critiques, ces plots comprenant des plots intérieurs situés dans la zone entre ces dites deux lignes opposées et des plots extérieurs placés de manière symétrique de part et d'autre des bords des lignes critiques, une étape de calcul des dimensions caractéristiques et de l'emplacement (S1, S2, S3, S4) dans le gap entre les deux fins de lignes critiques opposées de ladite structure d'intensification de contraste, une étape de génération de ladite structure et une étape de placement de ladite structure relativement aux fins desdites fins de lignes critiques opposées en fonction des paramètres déterminés.

7. Procédé de lithographie selon la revendication 6, **caractérisé en ce que** ladite structure d'intensification de contraste (370) est constituée par au moins deux CIF (CIF1, ... CIFᵢ...) ayant des dimensions propres (Lᵢ, lᵢ) substantiellement comprises entre 5 et 50 nm, lesdits motifs étant séparés l'un de l'autre par une distance S5 perpendiculaire aux lignes critiques sensiblement comprise entre 5 et 20 nm, le nombre de motifs étant choisi de telle manière que les plots extérieurs soient placés de manière symétrique de part et d'autre des bords des lignes critiques à une distance S1 perpendiculaire à la direction desdites lignes critiques comprise entre environ 5 et 50 nm.

8. Procédé de lithographie électronique de réseaux de lignes sur un substrat résiné comprenant une étape de sélection d'au moins deux lignes opposées du réseau ayant chacune une fin de ligne critique en opposition, les deux lignes étant séparées par un gap entre les deux fins de lignes critiques opposées, une étape de détermination de corrections à appliquer à la géométrie de la fin desdites lignes, ledit procédé comprenant en outre une étape de détermination d'au moins une structure d'intensification de contraste (390) choisie parmi plusieurs, ladite structure d'intensification de contraste étant constituée par deux rangées de plots sensiblement carrés traversant l'intérieur du gap entre ces dites deux lignes opposées, les deux rangées étant séparées dans la direction de la ligne critique, le nombre de plots étant choisi de telle manière que les plots extérieurs soient placés de manière symétrique de part et d'autre des bords des lignes critiques, une étape de calcul des dimensions caractéristiques et de l'emplacement (S1, S2, S3, S4) dans le gap entre les deux fins de lignes critiques opposées de ladite structure d'intensification de contraste, une étape de génération de ladite structure et une étape de placement de ladite structure relativement aux fins desdites fins de lignes critiques opposées en fonction des paramètres déterminés.

9. Procédé de lithographie selon la revendication 8, **caractérisé en ce que** les deux rangées de plots de ladite structure d'intensification de contraste (390) sont constituées de plots sensiblement carrés de dimension propre sensiblement comprise entre 5 et 20 nm, les deux rangées étant séparées d'une distance S1 dans la direction de la ligne critique sensiblement comprise entre 5 et 50 nm, le nombre de plots étant choisi de telle manière que les plots extérieurs soient placés de manière symétrique de part et d'autre des bords des lignes critiques à une distance S3 perpendiculaire à la direction desdites lignes critiques comprise entre environ 5 et 50 nm.

10. Procédé de lithographie selon l'une quelconque des revendications 1 à 9, **caractérisé en ce que** lesdits types de structures d'intensification de contraste, leurs dimensions et leurs emplacements sont déterminés par un modèle de détermination automatique d'un design cible comprenant les lignes critiques et les structures d'intensification de contraste optimales.

11. Procédé de lithographie selon l'une quelconque des revendications 1 à 10, **caractérisé en ce qu'**il comprend en outre au moins une étape de calcul d'au moins une dimension de ladite ligne critique et d'au moins une dimension d'une structure d'intensification de contraste et une étape de calcul de modulation de doses sur lesdites ligne critique et structure d'intensification de contraste, lesdits calculs étant liés par un critère d'optimisation choisi dans le groupe comprenant la latitude en énergie du procédé, la forme de la structure d'intensification de contraste, la position de ladite structure d'intensification de contraste, une combinaison de cette dernière avec la latitude en énergie du procédé.

12. Programme d'ordinateur comprenant des instructions de code de programme permettant l'exécution du procédé de lithographie électronique selon l'une des revendications 1 à 11 lorsque le programme est exécuté sur un ordinateur, ledit programme comprenant un module de sélection d'au moins deux lignes opposées du réseau ayant chacune une fin de ligne critique en opposition, un module de détermination de corrections à appliquer à la géométrie de la fin desdites lignes, ledit programme d'ordinateur comprenant en outre un module de détermination d'au moins une structure d'intensification de contraste choisie parmi plusieurs, un module de calcul des dimensions caractéristiques et de l'emplacement (S1, S2, S3, S4) dans le gap entre les deux fins de lignes critiques opposées de ladite structure d'intensification de contraste, un module de génération de ladite structure et un module de placement de ladite structure relativement aux fins desdites fins de lignes critiques opposées en fonction des paramètres déterminés.

13. Programme d'ordinateur selon la revendication 12, **caractérisé en ce qu'**il comprend en outre un module de calcul d'au moins une dimension de ladite ligne critique et d'au moins une dimension d'une structure d'intensification de contraste et un module de calcul de modulation de doses sur lesdites ligne critique et structure d'intensification de contraste, lesdits calculs étant liés par un critère d'optimisation choisi dans le groupe comprenant la latitude en énergie du procédé, la forme de la structure d'intensification de contraste, la position de ladite structure d'intensification de contraste, une combinaison de cette dernière avec la latitude en énergie du procédé.

## Patentansprüche

1. Elektronenstrahllithografieverfahren mit Netzwerken von Zeilen auf einem harzhaltigen Substrat, das den Schritt des Auswählens von wenigstens zwei gegenüberliegenden Zeilen des Netzwerks jeweils mit einem gegenüberliegenden kritischen Zeilenende beinhaltet, wobei die beiden Zeilen durch eine Lücke zwischen den zwei gegenüberliegenden kritischen Zeilenenden getrennt sind,
einen Schritt des Bestimmens von auf die Geometrie des Endes der Zeilen aufzubringenden Korrekturen, wobei das Verfahren ferner einen Schritt des Bestimmens eines Typs von wenigstens einer aus mehreren ausgewählten Kontrastintensivierungsstruktur (330), wobei die Kontrastintensivierungsstruktur eine H-Struktur mit einem Zweig lotrecht zur Richtung der kritischen Zeile ist, platziert in der Mitte der Lücke, und zwei Zweigen parallel zur Richtung der kritischen Zeile beinhaltet, platziert symmetrisch auf beiden Seiten der kritischen Zeile, einen Schritt des Berechnens der kritischen Abmessungen und der Lage (S1, S2, S3, S4) in der Lücke zwischen den zwei gegenüberliegenden kritischen Zeilenenden der Kontrastintensivierungsstruktur, einen Schritt des Erzeugens der Struktur und einen Schritt des Platzierens der Struktur relativ zu den Enden der gegenüberliegenden kritischen Zeilenenden in Abhängigkeit von bestimmten Parametern.

2. Lithografieverfahren nach Anspruch 1, **dadurch gekennzeichnet, dass** jeder der parallelen Zweige der H-Struktur spezifische Abmessungen zwischen etwa 5 und 50 nm hat und der Zweig der H-Struktur lotrecht zur Richtung der kritischen Zeile in der Mitte der Lücke in einer Distanz S2 vom Ende der kritischen Zeile gemäß der Richtung parallel zur kritischen Zeile zwischen etwa 5 und 50 nm platziert ist, und dessen Zweige parallel zur Richtung der kritischen Zeile auf symmetrische Weise auf beiden Seiten der kritischen Zeile in einer Distanz S3 lotrecht zur Richtung der kritischen Zeile zwischen 5 und 50 nm platziert sind.

3. Elektronenstrahllithografieverfahren mit Netzwerken von Zeilen auf einem harzhaltigen Substrat, das die folgenden Schritte beinhaltet: einen Schritt des Auswählens von wenigstens zwei gegenüberliegenden Zeilen des Netzwerks mit jeweils einem gegenüberliegenden kritischen Zeilenende, wobei die beiden Zeilen durch eine Lücke zwischen den zwei gegenüberliegenden kritischen Zeilenenden getrennt sind,
einen Schritt des Bestimmens von auf die Geometrie des Endes der Zeilen anzuwendenden Korrekturen, wobei das Verfahren ferner einen Schritt des Bestimmens eines Typs von wenigstens einer aus mehreren ausgewählten Kontrastintensivierungsstruktur (340, 350) beinhaltet, wobei die Kontrastintensivierungsstruktur von zwei parallelen Balken gebildet wird, auf symmetrische Weise platziert zwischen den zwei Zeilenenden gemäß einer Richtung lotrecht zu der kritischen Zeile, einen Schritt des Berechnens der charakteristischen Abmessungen und der Lage (S1, S2, S3, S4) in der Lücke zwischen den zwei gegenüberliegenden kritischen Zeilenenden der Kontrastintensivierungsstruktur, einen Schritt des Erzeugens der Struktur und einen Schritt des Platzierens der Struktur relativ zu den Enden der gegenüberliegenden kritischen Zeilenenden in Abhängigkeit von den bestimmten Parametern.

4. Lithografieverfahren nach Anspruch 3, **dadurch gekennzeichnet, dass** jeder der parallelen Balken der Kontrastintensivierungsstruktur spezifische Abmessungen zwischen etwa 5 und 50 nm hat, um eine Distanz S2 von zwischen etwa 5 und 100 nm beabstandet und jeweils vom Ende der kritischen Zeile um eine Distanz S4 parallel zur kritischen Zeile zwischen etwa 5 und 50 nm beabstandet.

5. Lithografieverfahren nach Anspruch 4, **dadurch gekennzeichnet, dass** die beiden parallelen Balken ferner jeweils an ihren Enden vier Pads mit spezifischen Abmessungen zwischen etwa 5 und 50 nm haben.

6. Elektronenstrahllithografieverfahren mit Netzwerken von Zeilen auf einem harzhaltigen Substrat, das die folgenden Schritte beinhaltet: einen Schritt des Auswählens von wenigstens zwei gegenüberliegenden Zeilen des Netzwerks jeweils mit einem gegenüberliegenden kritischen Zeilenende, wobei die beiden Zeilen durch eine Lücke zwischen den zwei gegenüberliegenden kritischen Zeilenenden getrennt sind,
einen Schritt des Bestimmens von auf die Geometrie des Endes der Zeilen anzuwendenden Korrekturen, wobei das Verfahren ferner einen Schritt des Feststellens von wenigstens einer aus mehreren ausgewählten Kontrastintensivierungsstruktur (370) beinhaltet, wobei die Kontrastintensivierungsstruktur Pads umfasst, deren größte Abmessung parallel zu den gegenüberliegenden zwei Zeilen ist, voneinander in der Richtung lotrecht zu den kritischen Zeilen getrennt, wobei diese Pads interne Pads umfassen, die sich in der Zone zwischen diesen beiden gegenüberliegenden Zeilen befinden, und externe Pads, die auf symmetrische Weise auf beiden Seiten der Ränder der kritischen Zeilen platziert sind, einen Schritt des Berechnens der charakteristischen Abmessungen und der Lage (S2, S2, S3, S4) in der Lücke zwischen den zwei Enden von gegenüberliegenden kritischen Zeilen der Kontrastintensivierungsstruktur, einen Schritt des Erzeugens der Struktur und einen Schritt des Platzierens der Struktur relativ zu den Enden der gegenüberliegenden kritischen Zeilenenden in Abhängigkeit von den bestimmten Parametern.

7. Lithografieverfahren nach Anspruch 6, **dadurch gekennzeichnet, dass** die Kontrastintensivierungsstruktur (370) durch wenigstens zwei CIF (CIF1, ... CIFᵢ... ) mit spezifischen Abmessungen (Lᵢ, Iᵢ) im Wesentlichen zwischen 5 und 50 nm gebildet werden, wobei die Muster um eine Distanz S5 lotrecht zu den kritischen Zeilen im Wesentlichen zwischen 5 und 20 nm voneinander getrennt sind, wobei die Anzahl von Mustern so gewählt wird, dass die externen Pads auf symmetrische Weise auf beiden Seiten der Ränder der kritischen Zeilen in einer Distanz S1 lotrecht zur Richtung der kritischen Zeilen zwischen etwa 5 und 50 nm platziert sind.

8. Elektronenstrahllithografieverfahren mit Netzwerken von Zeilen auf einem harzhaltigen Substrat, das die folgenden Schritte beinhaltet: einen Schritt des Auswählens von wenigstens zwei gegenüberliegenden Zeilen des Netzwerks jeweils mit einem gegenüberliegenden kritischen Zeilenende, wobei die beiden Zeilen durch eine Lücke zwischen den zwei gegenüberliegenden kritischen Zeilenenden getrennt sind,
einen Schritt des Bestimmens von auf die Geometrie des Endes der Zeilen anzuwendenden Korrekturen, wobei das Verfahren ferner einen Schritt des Bestimmens von wenigstens einer aus mehreren ausgewählten Kontrastintensivierungsstruktur (390) beinhaltet, wobei die Kontrastintensivierungsstruktur durch zwei Reihen von im Wesentlichen quadratischen Pads gebildet werden, die das Innere des Spalts zwischen diesen gegenüberliegenden zwei Reihen durchqueren, wobei die zwei Reihen in der Richtung der kritischen Zeile voneinander getrennt sind, wobei die Anzahl von Pads so gewählt wird, dass die externen Pads auf symmetrische Weise auf beiden Seiten der Ränder der kritischen Zeilen platziert werden, einen Schritt des Berechnens der charakteristischen Abmessungen und der Lage (S1, S2, S3, S4) in dem Spalt zwischen den zwei gegenüberliegenden kritischen Zeilenenden der Kontrastintensivierungsstruktur, einen Schritt des Erzeugens der Struktur und einen Schritt des Platzierens der Struktur relativ zu den Enden der gegenüberliegenden kritischen Zeilenenden in Abhängigkeit von den bestimmten Parametern.

9. Lithografieverfahren nach Anspruch 8, **dadurch gekennzeichnet, dass** die beiden Reihen von Pads der Kontrastintensivierungsstruktur (390) von im Wesentlichen quadratischen Pads mit spezifischen Abmessungen im Wesentlichen zwischen 5 und 20 nm gebildet werden, wobei die beiden Reihen um eine Distanz S1 in der Richtung der kritischen Zeile im Wesentlichen zwischen 5 und 50 nm getrennt sind, wobei die Anzahl von Pads so gewählt wird, dass die externen Pads auf symmetrische Weise auf beiden Seiten der Ränder der kritischen Zeilen in einer Distanz S3 lotrecht zur Richtung der kritischen Zeilen zwischen etwa 5 und 50 nm platziert werden.

10. Lithografieverfahren nach einem der Ansprüche 1 bis 9, **dadurch gekennzeichnet, dass** die Abmessungen und Lagen der Kontrastintensivierungsstrukturtypen durch ein automatisches Bestimmungsmodell eines Zieldesigns bestimmt werden, das die kritischen Zeilen und die optimalen Kontrastintensivierungsstrukturen umfasst.

11. Lithografieverfahren nach einem der Ansprüche 1 bis 10, **dadurch gekennzeichnet, dass** es ferner wenigstens einen Schritt des Berechnens von wenigstens einer Abmessung der kritischen Zeile und von wenigstens einer Abmessung einer Kontrastintensivierungsstruktur und einen Schritt des Berechnens der Modulation von Dosen auf den kritischen Zeilen und der Kontrastintensivierungsstruktur beinhaltet, wobei die Berechnungen durch ein Optimierungskriterium verbunden sind, ausgewählt aus der Gruppe bestehend aus der Energiebreite des Verfahrens, der Form der Kontrastintensivierierungsstruktur, der Position der Kontrastintensivierungsstruktur, einer Kombination der Letzteren mit der Energiebreite des Verfahrens.

12. Computerprogramm, das Programmcode-Befehle umfasst, die die Ausführung des Elektronenstrahllithografieverfahrens nach einem der Ansprüche 1 bis 11 zulässt, wenn das Programm auf einem Computer abgearbeitet wird, wobei das Programm ein Modul zum Auswählen von wenigstens zwei gegenüberliegenden Zeilen des Netzwerks jeweils mit einem gegenüberliegenden kritischen Zeilenende, ein Modul zum Feststellen von auf die Geometrie des Endes der Zeilen anzuwendenden Korrekturen umfasst, wobei das Computerprogramm ferner ein Modul zum Bestimmen von wenigstens einer aus mehreren ausgewählten Kontrastintensivierungsstruktur umfasst, ein Modul zum Berechnen der charakteristischen Abmessungen und der Lage (S1, S2, S3, S4) in der Lücke zwischen den zwei gegenüberliegenden kritischen Zeilenenden der Kontrastintensivierungsstruktur, ein Modul zum Erzeugen der Struktur und ein Modul zum Platzieren der Struktur relativ zu den Enden der gegenüberliegenden kritischen Zeilenenden in Abhängigkeit von bestimmten Parametern.

13. Computerprogramm nach Anspruch 12, **dadurch gekennzeichnet, dass** es ferner ein Modul zum Berechnen von wenigstens einer Abmessung der kritischen Zeile und wenigstens einer Abmessung einer Kontrastintensivierungsstruktur und ein Modul zum Berechnen der Modulation von Dosen auf den kritischen Zeile und einer Kontrastintensivierungsstruktur umfasst, wobei die Berechnungen durch ein Optimierungskriterium verbunden sind, ausgewählt aus der Gruppe bestehend aus der Energiebreite des Verfahrens, der Form der Kontrastintensivierungsstruktur, der Position der Kontrastintensivierungsstruktur, einer Kombination der Letzteren mit der Energiebreite des Verfahrens.

## Claims

1. A method of electron-beam lithography of networks of lines on a resin-coated substrate, comprising a step of selecting at least two opposite lines of the network, each having a critical line end in opposition, the two lines being separated by a gap between the two opposite critical line ends,
a step of determining corrections to be applied to the geometry of the end of said lines, said method further comprising a step of determining a type of at least one contrast intensification structure (330) chosen from several, said contrast intensification structure being an H-like structure having a branch perpendicular to the direction of said critical line placed in the middle of the gap and two branches parallel to the direction of said critical line placed in a symmetric manner on either side of said critical line, a step of calculating the characteristic dimensions and the location (S1, S2, S3, S4) in the gap between the two opposite critical line ends of said contrast intensification structure, a step of generating said structure and a step of placing said structure in relation to the ends of said opposite critical line ends as a function of the determined parameters.

2. The lithography method according to Claim 1, **characterised in that** each of the parallel branches of the H-like structure has inherent dimensions of between about 5 and 50 nm, and the branch of the H-like structure perpendicular to the direction of said critical line is placed in the middle of the gap at a distance S2 from the end of said critical line along the direction parallel to said critical line of between about 5 and 50 nm and whose branches parallel to the direction of said critical line are placed in a symmetric manner on either side of said critical line at a distance S3 perpendicular to the direction of said critical line of between about 5 and 50 nm.

3. A method of electron-beam lithography of networks of lines on a resin-coated substrate comprising a step of selecting at least two opposite lines of the network, each having a critical line end in opposition, the two lines being separated by a gap between the two opposite critical line ends,
a step of determining corrections to be applied to the geometry of the end of said lines, said method further comprising a step of determining a type of at least one contrast intensification structure (340, 350) chosen from several, said contrast intensification structure comprising two parallel bars placed in a symmetric manner between the two line ends along a direction perpendicular to said critical line, a step of calculating the characteristic dimensions and the location (S1, S2, S3, S4) in the gap between the two opposite critical line ends of said contrast intensification structure, a step of generating said structure and a step of placing said structure in relation to the ends of said opposite critical line ends as a function of the determined parameters.

4. The lithography method according to Claim 3, **characterised in that** each of the parallel bars of the contrast intensification structure has inherent dimensions of between about 5 and 50 nm, spaced apart by a distance S2 of between about 5 and 100 nm and each spaced from the end of said critical line by a distance S4 parallel to said critical line of between about 5 and 50 nm.

5. The lithography method according to Claim 4, **characterised in that** said two parallel bars further comprise four regions at each of their ends, each having inherent dimensions of between about 5 and 50 nm.

6. A method of electron-beam lithography of networks of lines on a resin-coated substrate, said method comprising a step of selecting at least two opposite lines of the network, each having a critical line end in opposition, the two lines being separated by a gap between the two opposite critical line ends,
a step of determining corrections to be applied to the geometry of said line ends, said method further comprising a step of determining at least one contrast intensification structure (370) chosen from several, said contrast intensification structure comprising regions whose largest dimension is parallel to said two opposite lines separated from one another in the direction perpendicular to the critical lines, these regions comprising interior regions situated in the zone between these said two opposite lines and exterior regions placed in a symmetric manner on either side of the edges of the critical lines, a step of calculating the characteristic dimensions and the location (S1, S2, S3, S4) in the gap between the two opposite critical line ends of said contrast intensification structure, a step of generating said structure and a step of placing said structure in relation to the ends of said opposite critical line ends as a function of the determined parameters.

7. The lithography method according to Claim 6, **characterised in that** said contrast intensification structure (370) comprises at least two CIFs (CIF1, ... CIFᵢ ...) having inherent dimensions (Lᵢ, Iᵢ) of substantially between 5 and 50 nm, said patterns being separated from one another by a distance S5 perpendicular to the critical lines of substantially between 5 and 20 nm, the number of patterns being chosen in such a way that the exterior regions are placed in a symmetric manner on either side of the edges of the critical lines at a distance S1 perpendicular to the direction of said critical lines of between about 5 and 50 nm.

8. A method of electron-beam lithography of networks of lines on a resin-coated substrate, said method comprising a step of selecting at least two opposite lines of the network, each having a critical line end in opposition, the two lines being separated by a gap between the two opposite critical line ends,
a step of determining corrections to be applied to the geometry of the end of said lines, said method further comprising a step of determining at least one contrast intensification structure (390) chosen from several, said contrast intensification structure comprising two rows of substantially square regions passing through the interior of the gap between these said two opposite lines, the two rows being separated in the direction of the critical line, the number of regions being chosen in such a way that the exterior regions are placed in a symmetric manner on either side of the edges of the critical lines, a step of calculating the characteristic dimensions and the location (S1, S2, S3, S4) in the gap between the two opposite critical line ends of said contrast intensification structure, a step of generating said structure and a step of placing said structure in relation to the ends of said opposite critical line ends as a function of the determined parameters.

9. The lithography method according to Claim 8, **characterised in that** the two rows of regions of said contrast intensification structure (390) comprise substantially square regions of an inherent dimension substantially between 5 and 20 mn, the two rows being separated by a distance S1 in the direction of the critical line of substantially between 5 and 50 nm, the number of regions being chosen in such a way that the exterior regions are placed in a symmetric manner on either side of the edges of the critical lines at a distance S3 perpendicular to the direction of said critical lines of between about 5 and 50 nm.

10. The lithography method according to any of Claims 1 to 9, **characterised in that** said types of contrast intensification structures, their dimensions and their locations are determined by a model for automatically determining a target design comprising the critical lines and the optimal contrast intensification structures.

11. The lithography method according to any of Claims 1 to 10, **characterised in that** it further comprises at least one step of calculating at least one dimension of said critical line and at least one dimension of a contrast intensification structure and a step of calculating modulation of doses on said critical line and contrast intensification structure, said calculations being related by an optimisation criterion chosen from the group comprising the process energy latitude, the shape of the contrast intensification structure, the position of said contrast intensification structure, a combination of the latter with the process energy latitude.

12. A computer programme comprising programme code instructions enabling execution of the electron-beam lithography method according to any of Claims 1 to 11 when the programme is executed on a computer, said programme comprising a module for selecting at least two opposite lines of the network, each having a critical line end in opposition, a module for determining corrections to be applied to the geometry of the end of said lines, said computer programme further comprising a module for determining at least one contrast intensification structure chosen from several, a module for calculating characteristic dimensions and the location (S1, S2, S3, S4) in the gap between the two opposite critical line ends of said contrast intensification structure, a module for generating said structure and a module for placing said structure in relation to the ends of said opposite critical line ends as a function of the determined parameters.

13. The computer programme according to Claim 12, **characterised in that** it further comprises a module for calculating at least one dimension of said critical line and at least one dimension of a contrast intensification structure and a module for calculating modulation of doses on said critical line and said contrast intensification structure, said calculations being related by an optimisation criterion chosen from the group comprising the process energy latitude, the shape of the contrast intensification structure, the position of said contrast intensification structure, a combination of the latter with the process energy latitude.
